# EUROPEAN PATENT APPLICATION

(11) **EP 0 613 179 A1**
(43) Date of publication of application: **31.08.1994**
(21) Application number: 94301403.5
(22) Date of filing: 28.02.1994
(51) Int. Cl.: H01L 23/473

(54) **Heat sink**

(30) Priority: 26.02.1993 GB 9303940
(71) Applicant: GEC ALSTHOM LIMITED, Rugby, Warwickshire CV21 1TB (GB)
(72) Inventor: Bassett,Roger John, Stone,Staffordshire ST15 8YD (GB); Buckingham,Andrew Douglas John, Warton,Tamworth,Staffordshire B79 0HN (GB)
(74) Representative: Keppler, William Patrick

(57) **Abstract**

A water cooled heat sink particularly for use with traction power semiconductor comprises a plate like body having channels in both faces separated by a central partition but forming a common circulatory channel. The channels are of spiral form the walls separating adjacent channels providing a support for a 'lid' which is sealed to each face. Water is then pumped through the channels, in contact with the 'lids' from an inlet to an outlet port. The 'lids' are formed by composite tiles, each consisting of a wafer of ceramic of good thermal conductivity, having on both sides a layer of copper intimately bonded to it. Maximum heat transference ability is achieved by the thin-ness of the tile and the channel structure, while maintaining the necessary electrical insulation.

## Description

This invention relates to heat sinks and particularly, but not exclusively, to heat sinks for use with power semiconductor assemblies in electric traction vehicles. Power semicondcutor devices, e.g. GTO thyristors, are commonly in the form of a semiconductor element between flat plate electrodes. In such electrical components a considerable amount of heat is generated in operation and this has to be removed if the device is not to be damaged by overheating.

It has been proposed to clamp the device between two flat-plate cooling blocks having passages through which a coolant liquid is pumped. It is also known to use a series of semiconductor devices and such cooling blocks alternately, so that both faces of the cooling blocks are used to absorb heat. In such arrangements, where a cooling block is sandwiched between two semiconductor devices the cooling blocks are sometimes referred to as intercoolers.

A further problem associated with the use of such electrical components is that the electrode face, from which heat is most easily extracted, is commonly at a high voltage, whereas the cooling block and its water supply (where water is used as the cooling fluid) may be required to be at earth potential. The interposition, between the electrode and the cooling block, of a layer of electrical insulation generally increases the thermal resistance of the path from semiconductor heat source to heat sink but is unavoidable in the particular circumstances.

An object of the present invention is to provide a heat sink for a heat-generating electrical component, the heat sink providing electrical insulation and a significantly reduced thermal resistance.

According to the present invention, a heat sink for an electrical component comprises a coolant enclosure of metal and of plate-like form having opposed plate surfaces, an internal metal partition structure providing mechanical support between the plate surfaces and also providing an extensive coolant interface determining a coolant flow path, the enclosure being closed on at least one of the plate surfaces by a tile member of elctrically insulating ceramic having a relatively low thermal resistance, the tile member having a layer of metal intimately bonded to the coolant face of the tile member and the layer of metal being intimately bonded to the coolant enclosure, and the heat sink futher comprising port means coupled to the enclosure forthe entry and exit of coolant. The metal layer is preferably one of two metal layers between which the ceramic layer is sandwiched and to which it is intimately bonded.

The partition structure may be provided by channel formed in the body of the coolant enclosure, the channels opening on to the plate surface and being closed by the tile member to form a coolant duct.

The channels preferably occupy a major part of the plate surface and the intervening walls are of generally curved form. The walls preferably extend up from an integral base portion and have a thickness which increases from the plate surface to the base portion. The wall thickness at the base portion may be approximately twice the wall thickness at the plate surface.

The channels are preferably of generally spiral form.

The enclosure may be circular and the outer metal layer of the tile member of smaller diameter than the enclosure to increase electrical breakdown resistance between the outer metal layer and the enclosure. The metal layer may be of copper and the enclosure also of copper.

The ceramic layer may be alumina or aluminium nitride. The heat sink may be double-sided, having a similar channel formation and tile member on each plate surface of the enclosure, the two channel formations being separated by a common integral base portion.

In an alternative embodiment the partition structure may comprise a honeycomb structure of prismatic ducts extending between the plate surfaces, each prismatic duct having a side aperture at each end into adjacent prismatic ducts to provide a coolant path between inlet and outlet port means which includes each of the prismatic ducts.

The honeycomb structure is preferably intimately bonded at all points of contact with the tile member or tile members.

The coolant enclosure may be encapsulated in an insulating resin, the tile member or members being exposed for abutment with a heat source.

Two embodiments of a heat sink for an electrical component in accordance with the invention will now be described, by way of example, with reference to the accompanying drawings, of which:
Figure 1 is an exploded perspective view of the first embodiment of heat sink;
Figure 2 is a part section of the assembled heat sink;
Figure 3 is a diagrammatic plan view of an alternative arrangement of coolant ports;
Figure 4 is a sectional view of an alternative tile arrangement for the first embodiment;
Figure 5 is a part perspective view of the second embodiment of heat sink.
Figure 6 is a plan view of part of the second embodiment with the tile member removed;
   and
Figure 7 is a section in a plane perpendicular to the tile members.

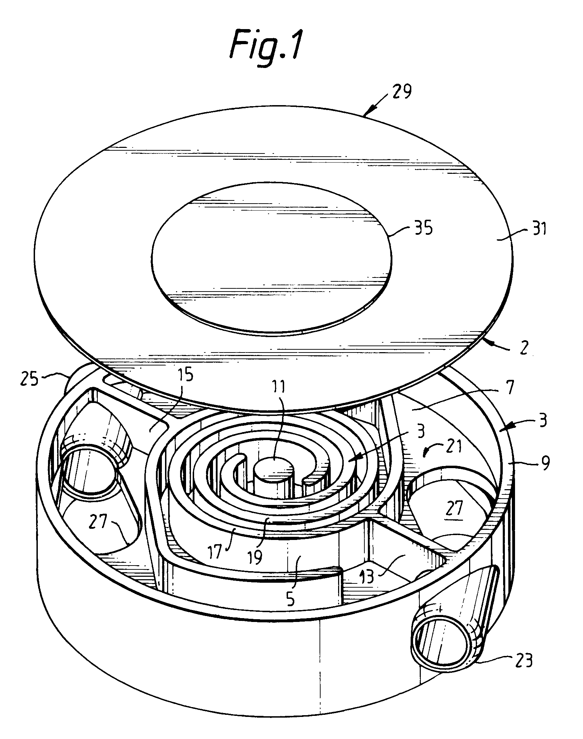

Referring now to Figures 1-4, the first embodiment of heat sink is basically in the form of a circular, plate-like, block or enclosure 1 of copper, chosen for its high thermal conductivity. The heat sink is of the intercooler type, for use between two similar semiconductor devices (not shown). The enclosure 1 is therefore of similar design on the upper and lower faces and in fact is symmetrical about a centre plane. The two faces 3 of the enclosure are flat and parallel and are each substantially relieved by the provision of a channel formation of largely spiral form. There are two spiral channels 5 and 7, interwound as it were, each starting from an outside or peripheral wall 9 and spiralling in to the centre at which there is a single pillar 11. The outer ends of the channels 5 and 7 are closed off from each other by radial walls 13 and 15.

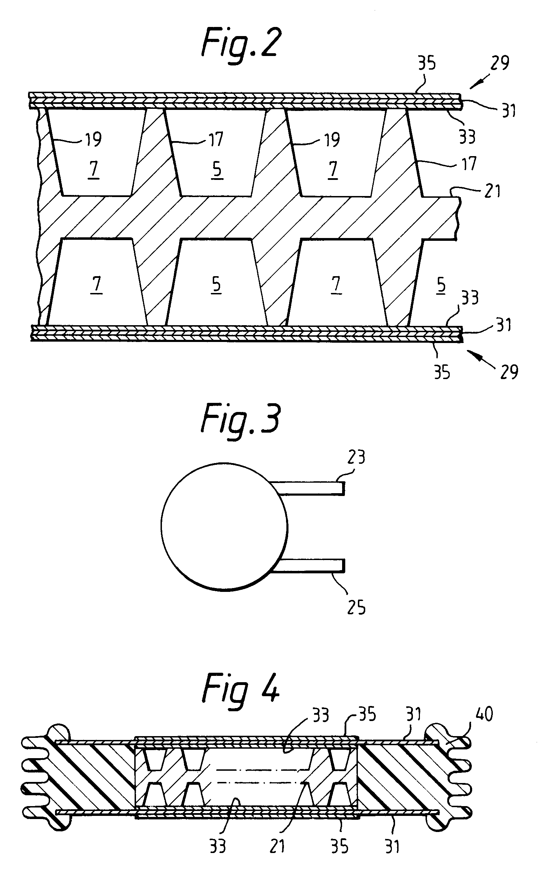

The channels 5 and 7 may be seen as formed by spiral walls 17 and 19 upstanding from a base portion 21 shown in Figure 2 more particularly.

At diametrically opposite positions in the peripheral wall are mounted two ports 23 and 25 each of which straddles the central base portion 21 to form a common circulatory channel, the two ports being directed in the same direction around the centre and providing access to the channel 5 and the channel 7 respectively. One port is designated the inlet port and coupled to a source of coolant, typically water or a mixture of water and glycol, and the other is coupled to a drain or heat exchanger and pump for recirculation.

A hole 27 is formed in the base portion adjacent the inner ends of the ports to permit intermingling of the coolant at entry and exit to balance temperature between the two faces of the heat sink to some degree.

It may be seen that the path of the coolant from, say, the port 23 extends into the channel 7 (reversing in direction after half a turn), around the spiral clockwise to the centre, and then anti-clockwise along the channel 5 to the outlet port 25. The situation on the lower face of the enclosure is a mirror image of that on the upper face.

The enclosure 1, and thus the channels 5 and 7 is closed to retain the coolant by tile members 29. Each tile consists of a ceramic layer or wafer 31, e.g. alumina or other ceramic having relatively good thermal conductivity, sandwiched between two layers 33 and 35 of copper which is intimately bonded to the ceramic. Alumina is a ceramic commonly used for isolation in semiconductor application in view of its good thermal conductivity (30 watts per metre Kelvin) compared to ceramics in general. Better examples, such as aluminium nitride, are known, but intimate bonding of this ceramic to copper or other metals, although a feature of the present design, has not hitherto been feasible. Suitable thicknesses of ceramic and copper are 0.6mm of alumina, or 2.0mm of aluminium nitride, bonded to 0.5mm of copper, these dimensions being as low as is practical in view of the forces involved. It is common practice to clamp the power transistors, GT0 thyristors or other semiconductor device, to the surface of the heat sink to improve the heat transference, i.e. reduce the thermal resistance. Considerable forces are therefore inposed on the tile 29 and the plate 1 when the same practice is adopted with the present heat sink. The tile thickness, and particularly the ceramic wafer thickness, must be sufficient, in conjunction with the manner of its support, as to enable the tile to withstand such forces.

A feature of the present invention is the formation of the spiral walls 17 and 19 defining the coolant channels. Not apparent in Figure 1, but shown in Figure 2, it may be seen that the walls 17 and 19 are of tapered form being approximately twice as thick at the base as they are at the tile face. This design gives good mechanical strength to the wall while not restricting the heat flow path unduly, and also allows the base portion 21 to be manufactured by casting. The spacing of the walls is also set to give them sufficient compressive strength to resist the clamping forces but may vary in width between the centre and outer edge of the plate 3 to facilitate more efficient cooling.

In an alternative embodiment shown in Figure 3, the inlet and outlet ports are disposed on the same side of the enclosure but accessing the respective channels 5 and 7.

The structure of the tile 29, with a minimally thin layer of copper 33 intimately bonded to the inner face, permits in effect the closing and sealing of the coolant channels by the electrically insulating ceramic wafer 31. The copper layer 33 is bonded by brazing or fusion, to the contacting wall surfaces. This bonding process may be applied between only the peripheral wall 9 and the tile, leaving the remaining walls to transfer heat by forcible contact only. In this case a greater proportion of the heat generated has to be taken by the fluid. The preferred method is to bond every wall to the copper layer 33 since the walls do serve to transfer a considerable part of the total heat and any thermally resistive interface will detract from the overall efficiency. Adhesive bonding, even using a conductive adhesive, is much less satisfactory.

The outer copper layer 35 could be dispensed with, with again some loss of efficiency. The electrical component has to be clamped to the heat sink in any event so there will inevitably be less than perfect contact between component and heat sink. However, the use of the copper layer 35 does assist considerably in dispersing the heat from high contact pressure points more widely over the ceramic layer.

Whether the outer copper layer 35 is present or not there may be provided an electrical connector plate between the component and the tile. Alternatively the outer copper layer 35 itself may be provided with an electrical connection for the component.

The preferred embodiment is clearly that in which the inner copper layer is bonded at all contact points with the plate 1, and in which an outer bonded copper layer 35 is employed between the ceramic layer and the electrical component.

In view of the small thickness of the tile member there is some danger that there will occur electrical breakdown between the outer 'live' copper layer 35 and the inner copper layer 33 which presents an 'earth' at the outer edge of the tile. This is avoided in the present embodiment by using a heat sink which is of greater diameter than the electrode of the component to be clamped to it as indicated in Figure 1 where the outer copper layer 35 is formed to be of smaller diameter than the remainder of the tile, leaving an insulation path length equal to the difference of radii between the tile 29 and the outer copper layer 35.

In this case the plate 1 may be formed with the spiral walls 17 and 19 relatively closely spaced in the inner region backing the layer 35, and relatively widely spaced in the outer region, as shown in Figure 1.

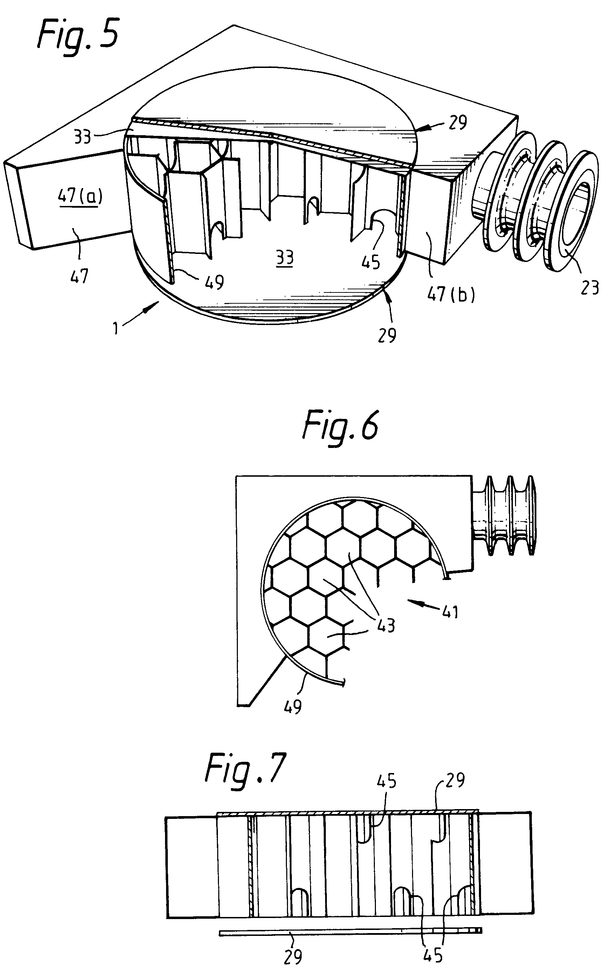

In an alternative embodiment shown in section in Figure 4, the ceramic layer in the tile may extend radially beyond both inner and outer copper layers 33 and 35. Both tiles may be of this form to provide a long breakdown path between the component and the earthed heat sink. The intervening space between the ceramic layers is then preferably filled with an insulating filler 40 of suitable flexible plastic or other material, e.g. glass or ceramic particles embedded in a flexible material. This filler also provides a mechanical support for the protruding parts of the ceramic tiles 31.

In an alternative arrangement, the inner and outer metal layer of the tile may be of the same diameter as the enclosure and the tile ceramic extend beyond the layers. The tile edge is then fitted with rubber edging to inhibit the tracking path around the tile. Such rubber edging being exposed to atmosphere should preferably be shedded.

While the embodiment described above is a double-sided device, for use as an 'intercooler' sandwiched between heat generating devices, it will be apparent that a single-sided device could be employed in which the base portion 21 was one end wall of the device. The electrical component would of course then be clamped to the tile surface as before.

It may be seen that the combined design of the plate, coolant channel walls and tile structure provides a heat sink of very low thermal resistance and consequently great efficiency.

Referring now to Figures 5,6, and 7, these show a double sided heat sink in which the enclosure 1 is formed from sheet metal (copper) rather than cast in solid block form. The enclosure comprised a peripheral wall 49 of cylindrical form sandwiched between two tiles 29. Within the wall 49 is a honeycomb structure of prismatic ducts 43 of hexagonal cross section, as shown clearly in Figure 6. The ducts 43 extend the full height of the enclosure and are closed off by the tile member 29 at each end. Each duct 43 has an aperture 45 at each end in two different faces of the hexagon, the choice of hexagon sides being such that continuous coolant path is provided throughout the enclosure between an inlet port 23 and an outlet port cut away in the drawings to show the internal construction.

Figure 5 is a partially exploded view, the lower tile 29 being separated from the enclosure 1. It should also be noted that the surfaces 47(a) and 47(b) do not exist - they are cut-away surfaces as provided by computer graphics.

The enclosure 1 is encapsulated in a resin block 46 which completely surrounds the enclosure but leaves the tiles 29 exposed for contacting projecting poles on the conductor bars of the associated semiconductor devices. The resin casing encloses the projecting edges of the tiles. The insulation extends continuously around the inlet (23) and outlet ports, these being shedded as shown to increase the tracking path between tile conductor layer 35 and the earthed coolant tubes.

The honeycomb structure 41 is bonded to the tile inner copper layer 33 by brazing or thermal diffusion bonding to provide maximum conduction from the tile layer into the coolant. Considerable axial strength is provided by the honeycomb structure to resist the applied clamping forces, while at the same time providing some compliance to radial forces.

## Claims

1. A heat sink for an electrical component, the heat sink comprising a coolant enclosure of metal and of plate-like form having opposed plate surfaces, an internal metal partition structure providing mechanical support between the plate surfaces and also providing an extensive coolant interface determining a coolant flow path, the enclosure being closed on at least one of the plate surfaces by a tile member of electrically insulating ceramic having a relatively low thermal resistance, the tile member having a layer of metal intimately bonded to the coolant face of the tile member and the layer of metal being intimately bonded to the coolant enclosure, and the heat sink further comprising port means coupled to the enclosure for the entry and exit of coolant.

2. A heat sink according to Claim 1, wherein said metal layer (33) is one of two metal layers (33,35) between which the ceramic layer (31) is sandwiched and to which it is intimately bonded.

3. A heat sink according to Claim 1 or Claim 2, wherein said partition structure is provided by channels formed in the body of the coolant enclosure, the channels opening on to the plate surface and being closed by said tile member to form a coolant duct.

4. A heat sink according to Claim 3, wherein said channels (5,7) occupy a major part of plate surface and the intervening walls (17,19) are of generally curved form.

5. A heat sink according to Claim 4, wherein said walls (17,19) extend up from an integral base portion (21) and have a thickness which increases from the plate surface to the base portion (21).

6. A heat sink according to Claim 5, wherein the wall thickness at the base portion (21) is approximately twice the wall thickness at the plate surface.

7. A heat sink according to any of Claims 3 to 6, wherein said channels (5,7) are of generally spiral form.

8. A heat sink according to Claim 7, wherein walls formed between said channels (5,7) are of varying thickness from the outer periphery to the centre.

9. A heat sink according to Claim 7 or Claim 8, wherein inlet and outlet ports (23,25) for coolant are incorporated in a peripheral wall (9) of the enclosure and the channels (5,7) comprise interleaved ingoing and outgoing channels.

10. A heat sink according to Claim 9, wherein the enclosure is circular, the spiral channels (5,7) are formed by interleaved spiral walls (17,19), each spiral wall being connected to the peripheral wall (9) by respective diametrically opposite wall sections (13,15) to separate the channels (5,7).

11. A heat sink according to any of Claims 7 to 10, wherein the enclosure (1) is circular and the outer metal layer (35) of the tile member (29) is of smaller diameter than the enclosure (1) to increase electrical breakdown resistance between the outer metal layer (35) and the enclosure (1).

12. A heat sink according to Claim 10, wherein said spiral walls (17,19) are relatively closely spaced in a central region of the enclosure (1) and relatively widely spaced in the outer region of the enclosure, the arrangement being such as to provide greater mechanical compressive strength in the central region for the support of an electrical component urged against the outer metal layer (35).

13. A heat sink according to any preceding claim, wherein the inner metal layer (33) on the coolant face of the tile memberis bonded to the enclosure (1) by brazing.

14. A heat sink according to any of Claims 1-12, wherein said inner metal layer (33) is bonded to the enclosure (1) by fusion bonding.

15. A heat sink according to any of Claims 1-12, wherein said inner metal layer (33) is bonded to the enclosure (1) by highly conductive adhesive.

16. A heat sink according to any preceding claim, wherein said inner metal layer (33) is bonded to the enclosure (1) and partition (17,19,41) structure at all points of contact.

17. A heat sink according to any preceding claim, wherein said inner metal layer (33) is copper and said enclosure (1) is copper.

18. A heat sink according to any preceding claim, wherein the ceramic layer (31) is alumina.

19. A heat sink according to any of Claims 1-17, wherein the ceramic layer (31) is aluminium nitride.

20. A heat sink according to any preceding claim, having a similar channel formation and tile member (29) on each plate surface of the enclosure (1), the two channel formations (5,7) being separated by a common integral base portion (21).

21. A heat sink according to Claim 20 wherein the ceramic layer (31) extends beyond each said metal layer (35) and beyond the enclosure (1).

22. A heat sink according to Claim 21, wherein the region around the enclosure (1) and between the ceramic layers (31) is filled with flexible insulation material (40).

23. A heat sink according to Claim 20 as appendent to Claim 9, wherein said inlet and outlet ports (23,25) each straddle the base portion (21) so as to access both channel formations (5,7).

24. A heat sink according to Claim 1 or Claim 2, wherein said partition structure comprises a honeycomb structure (41) of prismatic ducts (43) extending between the plate surfaces, each prismatic duct (43) having a side aperture (45) at each end into adjacent prismatic ducts (43) to provide a coolant path between inlet (23) and outlet port means which includes each of the prismatic ducts (43).

25. A heat sink according to Claim 24, wherein said honeycomb structure (41) is intimately bonded at all points of contact with a tile member inner metal layer (33).

26. A heat sink according to Claim 24 or Claim 25, wherein each prismatic duct (43) is of hexagonal section.

27. A heat sink according to any of Claims 24-26, wherein the coolant enclosure is encapsulated in an insulating resin (47) the tile member (29) being exposed for abutment with a heat source.
